# EUROPÄISCHE PATENTSCHRIFT

(11) **EP 1 260 122 B1**
(45) Veröffentlichungstag und Bekanntmachung des Hinweises auf die Patenterteilung: **01.02.2006**
(21) Anmeldenummer: 01921158.0
(22) Anmeldetag: 02.03.2001
(51) Int. Cl.: H05K 5/02, H02B 1/28, H02B 1/56

(54) **ANORDNUNG ZUM KÜHLEN VON ELEKTRISCHEN BAUGRUPPEN SOWIE TEILE DAVON**
ASSEMBLY FOR COOLING ELECTRIC MODULES AND COMPONENTS THEREOF
DISPOSITIF POUR REFROIDIR DES BLOCS ELECTRIQUES ET DES COMPOSANTS DE CEUX-CI

(30) Priorität: 03.03.2000 DE 10010454
(43) Veröffentlichungstag der Anmeldung: 27.11.2002
(73) Patentinhaber: SIEMENS AKTIENGESELLSCHAFT, 80333 München (DE)
(72) Erfinder: REECK, Guido, 85521 Ottobrunn (DE)
(86) Internationale Anmeldenummer: PCT/DE2001/000797
(87) Internationale Veröffentlichungsnummer: WO 2001/065898

(56) Entgegenhaltungen:
- EP-A- 0 654 877
- DE-C- 4 312 664
- DE-U- 1 779 890
- DE-U- 9 104 761
- DE-U- 29 619 902
- SIMEK B: "TAMPER RESTRICTIVE THERMAL VENTILATION SYSTEM FOR ENCLOSURES REQUIRING VENTILATION AND PHYSICAL SECURITY" MOTOROLA TECHNICAL DEVELOPMENTS,US,MOTOROLA INC. SCHAUMBURG, ILLINOIS, Bd. 34, 1. März 1998 (1998-03-01), Seite 125 XP000781048

## Beschreibung

Die Erfindung betrifft eine Anordnung zum Kühlen von in einem Gehäuse angeordneten elektrischen Baugruppen, insbesondere zum Kühlen einer Basisstation eines Mobilfunksystems oder drahtlosen Teilnehmeranschlußsystems, sowie einzelne Teile einer derartigen Anordnung.

In einem elektrisch betriebenen technischen Gerät führt die Verlustleistung stromdurchflossener Bauelemente und Baugruppen zu einer Erwärmung des Geräts. Da elektrische Standardbauelemente für technische Geräte nur einen begrenzten zulässigen Betriebstemperaturbereich von beispielsweise bis zu 70°C aufweisen, werden diese durch Kühleinrichtungen gekühlt. Diese Kühleinrichtungen sind beispielsweise Ventilatoren, die in dem Gehäuse eine die elektrischen Bauelemente und Baugruppen durchströmende Luftströmung aufbauen und somit ein Abführen der erzeugten Wärmeleistung bewirken.

Bei einem Betrieb des technischen Geräts außerhalb geschlossener Räume oder in widrigen Verhältnissen innerhalb geschlossener Räume ist neben der Wärmeabfuhr zusätzlich ein ausreichender Schutz vor Umwelteinflüssen wie beispielsweise Schmutz und Flüssigkeiten, üblicherweise Wasser, vorzusehen. Dabei sind Schutzbestimmungen nach den spezifizierten IP-Klassen einzuhalten, um eine dauerhafte Funktion des technischen Geräts, d.h. beispielsweise der benannten Basisstation eines Mobilfunksystems, zu gewährleisten.

Aus EP0654877 ist eine Tür eines Schaltschranks mit Lüftungsöffnungen bekannt. Die Lüftungsöffnungen sind dabei durch ein Abdeckteil, das ebenfalls Lüftungsöffnungen aufweist, abdeckbar. Nach dem Zusammenfügen von Tür und Abdeckteil entstehen V-förmige Lüftungsöffnungen, die einen geradlinigen Durchtritt ins Schaltschrankinnere verhindern.

Aus DE 29619902U1 ist ein Filterltifter für einen Einbau in eine Schaltschrankwand bekannt. Dabei ist hinter einem Abdeckgehäuse eine Filtermatte angeordnet. Beide werden mit Hilfe einer Schnellbefestigungseinrichtung an einem Grundgehäuse befestigt.

Aus der DE 19755944 ist bekannt, in einem Lufteinlaß eines Gehäuses ein Membranfilter für eine Oberflächenfilterung von Schmutzpartikeln aus einströmender Kühlluft und für ein Abscheiden von Flüssigkeiten vorzusehen. Im Vergleich mit einem beispielsweise aus der DE 19626778 bekannten Gehäuse mit einem Luft/Wärmetauscher, der eine vollständige Trennung eines inneren Kühlkreislaufes von einem äußeren Kühlkreislauf sicherstellt, kann durch den Einsatz des Membranfilters in einfacher Weise ein ausreichender Schutz der elektrischen Baugruppen für die oben genannten Einsatzgebiete des technischen Geräts mit den entsprechenden Schutzbestimmungen erreicht werden. Gleichzeitig wird eine für die Kühlung benötigte Temperaturdifferenz zwischen der Umgebungstemperatur und der Temperatur im Inneren des Gehäuses verringert.

Ein derartiges Membranfilter basiert beispielsweise auf einer unter der Bezeichnung Goretex (Marke), Sympatex (Marke) etc. für die Anwendung in Bekleidungsgegenständen bekannten Membrane. Die Membrane des Filters bestehe aus einem feinen Geflecht oder Gewirk vcn Fasern, das eine sehr kleine Porengröße ermöglicht. Als Material hierfür wird beispielsweise PTFE (Polytetrafluorethylen), das mehr unter dem Namen Teflon geläufig ist, verwendet. Die Membrane wird in der Regel auf einem textilähnlichem Trägermaterial, beispielsweise Polyamid, verwirklicht, um eine bestimmte Stabilität des Membranfilters zu erreichen. Um eine möglichst große Filteroberfläche zu erhalten, so daß der durch das Membranfilter erzeugte Strömungswiderstand für die Kühlluft möglichst gering bleibt, wird die auf das Trägermaterial auflaminierte Membrane vergleichbar einer Ziehharmonika gefaltet, damit diese große Filteroberfläche in einer kleinen Rahmenfläche untergebracht werden kann.

Ferner müssen Schutzbestimmungen hinsichtlich der EMV-Richtlinien (EMV - Elektromagnetische Verträglichkeit) erfüllt sein, und zwar einerseits zum Schutz der in dem Gehäuse angeordneten Geräte vor äußerer Strahlung und andererseits zum Schutz der Umgebung vor der von den elektrischen Baugruppen ausgehenden Strahlung. Dies wird im allgemeinen durch eine entsprechende Abschirmung, beispielsweise ein geeignetes Drahtgeflecht oder ein Geflecht aus elektrisch leitfähigem Material, erreicht.

Da insbesondere Basisstationen eines Mobilfunksystems in freier Umgebung aufgestellt werden, sind sie, wie bereits erwähnt, den Einflüssen von Wind und Wetter ausgesetzt, und zwar insbesondere Feuchtigkeit und Wasser, d.h. Regen. Beispielsweise kann es zu extremen Niederschlägen mit entsprechendem Spritzwasser kommen, wobei das Membranfilter einer gattungsgemäßen Anordnung einem derartig intensiven Wasserstrahl nicht ausgesetzt werden kann, da die Gefahr der Zerstörung der Membrane besteht. Ferner kann es unter bestimmten Umgebungsbedingungen dazu kommen, daß die relative Luftfeuchtigkeit der Kühlluft innerhalb einer eine Basisstation enthaltenden gattungsgemäßen Anordnung über einen für die Baugruppen der Basisstation kritischen Wert steigt.

Ein weiteres Problem ist die Ausführung des normalerweise in einer Tür oder einer Wand einer derartigen Anordnung zum Kühlen angeordneten Membranfilters. Durch die horizontale Faltung des Membranfilters bleibt Feuchtigkeit bzw. Kondenswasser und zwischen Türblatt und Filter eingedrungenes Spritzwasser in der Faltung des Membranfilters stehen. Ferner sammelt sich ablaufendes Wasser auf dem Sockel, der sich in der Tür zur Aufnahme des Membranfilters befindet. Dieses Wasser kann zu einer Beeinträchtigung der Filterfunktion des Filters, zu einem Rosten des Membransockels, falls diese, wie üblich, aus Blech ist, und/oder zu einer Erhöhung der Luftfeuchtigkeit im Innern des Gehäuses führen.

Der Erfindung liegt daher die Aufgabe zugrunde, den Schutz elektrischer Baugruppen, die in einer mit Membranfiltern versehenen Anordnung zur Kühlung angeordnet sind, insbesondere einer Basisstation eines Mobilfunksystems, zu verbessern.

Die Aufgabe wird durch die Merkmale der unabhängigen Ansprüche gelöst. Bevorzugte Ausgestaltungen der Erfindung sind Gegenstand der Unteransprüche.

Die Anordnung zum Kühlen von elektrischen Baugruppen weist eine den elektrischen Baugruppen vorgelagerte Wand auf, die ein mit Lüftungslöchern versehenes Wandelement und einen an der Innenseite des Wandelements angeordnetes Membranfilter umfasst, wobei durch die Lüftungslöcher eintretende Luft durch das Membranfilter geführt wird.

Das Membranfilter weist erfindungsgemäß eine Faltung mit im wesentlichen senkrecht verlaufenden Längsfalten auf. Dadurch wird vermieden, daß Wasser oder Feuchtigkeit in den Falten eines derartigen Filters stehen bleibt und sich so nachteilig auswirkt, beispielsweise durch Erhöhung der Luftfeuchtigkeit der einströmenden Kühlluft oder durch langfristige Verrottung des Materials. Ferner hat eine Längsfaltung, d.h. senkrecht verlaufende Faltungen des Membranfilters, den Vorteil, das der sich an der Oberfläche des Filters bildende Filterkuchen leichter abfällt, da das Gewicht des Filterkuchens früher die Adhäsionskräfte der Filtermembranoberfläche übersteigt. Dadurch werden vorteilhafterweise längere Wartungs- bzw. Reinigungsintervalle des Membranfilters erreicht.

In einer weiteren bevorzugten Ausführungsform weist ein Rahmenfuß eines den Membranfilter aufnehmenden Rahmens einer Wand bzw. einer Tür eine nach außen weisende Schräge auf, so daß vom Membranfilter ablaufendes Wasser nach außen abgeleitet wird. Vorzugsweise ist in der Umgebung des Rahmenfußes mindestens eine Öffnung zum Ablaufen des Wassers angeordnet.

In einer weiteren bevorzugten Ausführungsform weist das Membranfilter einschließlich seines Filterrahmens eine Neigung gegenüber der Senkrechten auf, so daß Wasser leicht aus der Filterfaltung ablaufen kann. Insbesondere eignet sich diese Ausführungsform auch für Membranfilter mit horizontaler Faltung.

Eine erfindungsgemäße Wand bzw. Tür einer Anordnung zum Kühlen von elektrischen Baugruppen weist ein mit Lüftungslöchern versehenes Wandelement oder Türelement auf. Dabei ist an der Innenseite des Wand- und/oder Türelements das Membranfilter angeordnet, so daß die durch die Lüftungslöcher eintretende Luft durch das Membranfilter geführt wird.

Zur Verhinderung des Wassereintritts weist das Wandelement bzw. Türelement sog. zweiseitige Lamellen auf, die ineinander versetzt und nach unten offen angeordnet sind, so daß jeder durch die Lamellenanordnung führender Weg eine Krümmung aufweist. Die Form einer derartigen Lamelle ist daher U-förmig oder V-förmig, wobei damit keine Eingrenzung auf die U- bzw. V-Form gemeint ist. Dadurch wird gewährleistet, daß ein direkt auf die Wand auftreffender Wasserstrahl keinen Druck auf die hinter dem Wand- oder Türelement angeordnete Membrane des Membranfilters ausüben kann, da der Wasserstrahl an der Lamelle gebrochen bzw. zerstäubt wird und seine Energie an die Lamellenkonstruktion abgibt.

Ein derartiges Wand- oder Türelement umfaßt zwei Wand- oder Türelementhälften, wobei jede Elementhälfte mit sog. einseitigen Lamellen versehen ist, so daß nach dem Zusammenfügen der beiden Elementhälften ein Wand- oder Türelement mit zweiseitigen Lamellen entsteht. Dabei ist das Wand bzw. Türelement so ausgestaltet, daß die zweiseitigen Lamellen nach unten offen sind und sich überlappen, damit einerseits das Wasser nach unten abfließen kann und anderseits durch die Überlappung kein gerader Weg durch die zweiseitige Lamelle für einen Wasserstrahl möglich ist.

Vorzugsweise werden die einseitigen Lamellen aus der Elementhälfte ausgestanzt und die beiden Elementhälften, die identisch ausgebildet sind, werden auf ihren Rückseiten, d.h. den Seiten ohne die durch die Stanzung erzeugten einseitigen Lammellen durch Fügetechniken wie beispielsweise Löten, Schweißen, Nieten, Schrauben und/oder Kleben miteinander zu einem Wand- oder Türelement flächig verbunden. Von Vorteil ist hierbei die rationelle Fertigung der Wand- oder Türelemente.

Es ist auch möglich, die Wand- oder Türelelementhälften mit darin integrierten Halblamellen durch ein Spritzgußverfahren zu erzeugen und anschließend die Elementhälften zusammenzufügen.

In einer weiteren bevorzugten Ausführungsform ist der gesamte Filterblock bestehend aus Rahmen und darin angeordnetem Membranfilter als Wand bzw. Tür ausgebildet, wobei der Rahmen die notwendigen Elemente, wie beispielsweise Befestigungselemente für Baugruppen, Abdichtungen, Türschaniere etc., zur Erfüllung der Wandfunktion aufweist. Dies ermöglicht eine einfache und rationelle Art der Fertigung sowie einen schnellen Austausch der Wand bzw. Tür.

Vorzugsweise weist die Wand eine Filtermembrane auf, die an der Außenseite mit einem geeigneten Material wie Kunststoff entsprechend der gewünschten Wandform hinterspritzt ist, wobei an den Stellen des Lufteinlasses kein Material angeordnet ist. Durch diese Ausführungsform erhält man sozusagen eine stabile Wand bzw. Tür mit integriertem Membranfilter. Ferner kann die Wand bzw. Tür mit weiteren Elementen ausgestattet sein, so können beispielsweise die Luftlöcher in Lamellenform ausgeführt sein, wodurch die Filtermembrane gegen direkte Druckausübung geschützt ist. Ferner kann die Wand bzw. Tür ein Fliegengitter und/oder eine EMV-Abschirmung aufweisen, das vor der Membrane des Membranfilters an der Innenseite des Wandelements angeordnet ist.

In einer weiteren bevorzugten Anordnung zum Kühlen von elektrischen Baugruppen ist im Innern des Gehäuses der Anordnung ein Feuchtesensor angeordnet. Ferner weist die Anordnung ein vor dem mindestens einen Membranfilter angeordnetes Heizelement auf, wobei das Heizelement die einströmende Luft erwärmt, wenn der Feuchtesensor einen Feuchtigkeitsgehalt im Innern der Anordnung detektiert, der einen vorbestimmten Wert übersteigt. Somit wird die relative Luftfeuchtigkeit im Innern der Anordnung herabgesetzt.

Merkmale oder Elemente der verschiedenen Wand- bzw. Türen können selbstverständlich in geeigneter Weise miteinander kombiniert werden.

Bevorzugte Ausführungsformen der Erfindung werden nachfolgend anhand der Zeichnungen erläutert.
Fig. 1 zeigt einen Querschnitt durch eine Anordnung zum Kühlen von elektrischen Baugruppen in schematischer Darstellung,
Fig. 2 zeigt einen Querschnitt durch eine Tür oder ein Wandelement nach dem Stand der Technik,
Fig. 3 zeigt einen Querschnitt durch eine Tür oder ein Wandelement gemäß der Erfindung, und
Fig. 4 zeigt in schematischer Darstellung ein Tür- oder Wandelement mit hinterspritzter Membran.

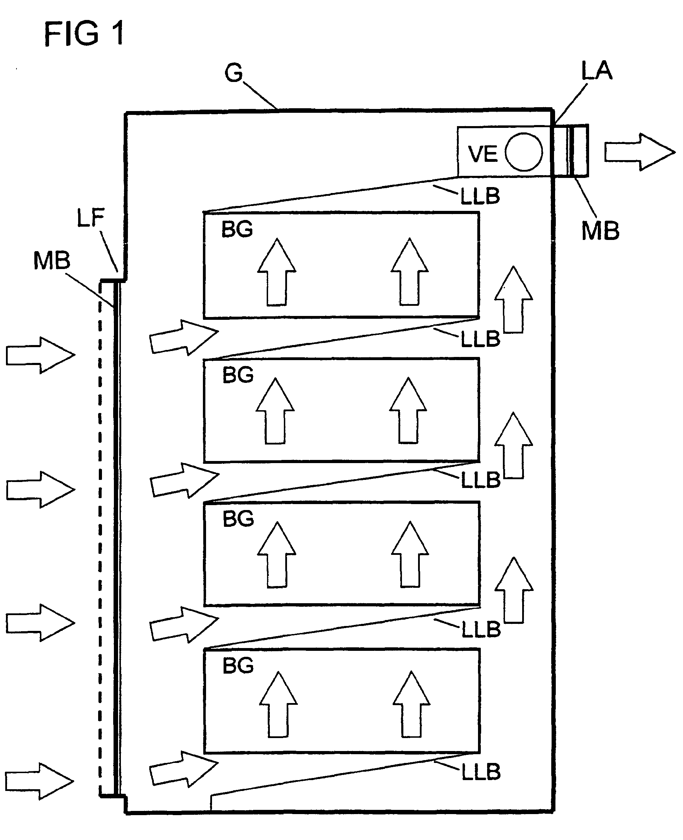

Fig. 1 zeigt eine Anordnung zum Kühlen eines technischen Geräts, wie beispielsweise einer Basisstation eines Mobilfunksystems oder drahtlosen Teilnehmeranschlußsystems. Das sogenannte technische Gerät weist eine oder mehrere elektrische Baugruppen BG auf, die während des Betriebes Wärme an ihre Umgebung abgeben, wodurch die Notwendigkeit einer Kühlung entsteht, um eine maximal zulässige Betriebstemperatur der Baugruppen BG oder einzelner elektrischer Bauelemente nicht zu überschreiten.

Das in Seitenansicht dargestellte Gehäuse G der Anordnung weist mindestens einen entsprechend ausgestalteten Lufteinlaß LF mit einem Membranfilter MB auf, wobei die Ausmaße und Anordnung des Lufteinlasses LF derart sind, daß eine geeignete Kühlung der Baugruppen durch einen entsprechenden Luftstrom erfolgt, der schematisch durch Pfeile angedeutet ist. Ferner ist die aktive Oberfläche des Membranfilters MB, welche beispielsweise durch eine Faltenbildung größer als der Lufteinlaß LF sein kann, so gestaltet, daß der Druckabfall der einströmenden Kühlluft durch eine im Luftauslaß LA angeordnete Kühleinrichtung VE, beispielsweise einen Ventilator, kompensiert werden kann und immer eine ausreichende Menge Kühlluft einströmen kann. Der Luftauslaß LA kann ebenfalls einen Membranfilter aufweisen. Ferner können im Gehäuse Luftleitbleche LLB angeordnet sein, die geeignete Luftströmungen aufbauen.

Zur Verhinderung eines hohen Staudrucks sind die elektrischen Baugruppen BG und die Luftleitbleche LLB derart angeordnet, daß gleichmäßig Kanäle ohne Engpässe entstehen, deren Krümmungen minimiert sind. Ein Drucksensor im Innern des Gehäuses G kann zudem den Staudruck messen und die Kühleinrichtung derart ansteuern, daß ein die Membrane gefährdender Staudruck vermieden wird.

Das Membranfilter MB kann in einem Rahmen angeordnet sein, der eine schnelle Herausnahme der aus dem Membranfilter und dem Rahmen bestehenden Membranfilterkassette zu Wartungs- und Reinigungszwecken bzw. zum Austausch ermöglicht. Gleichzeitig ermöglicht der Rahmen eine beschriebene Faltung des Membranfilters MB. Der Rahmen kann zur Beschränkung der Ausmaße des technischen Gerätes auch in das Gehäuse G integriert werden.

Das Membranfilter MB ist als ein Oberflächenfilter ausgeführt, der die besonders vorteilhafte Eigenschaft besitzt, Schmutzpartikel und Flüssigkeiten der Umgebungsatmosphäre bereits an der Oberfläche der Membrane abzuscheiden, wodurch beispielsweise empfindliche elektronische Bausteine oder Schaltungen in den Baugruppen BG gegen derartige Umwelteinflüsse geschützt werden. Ein derartiger Membranfilter MB basiert, wie bereits erwähnt, auf einer unter der Bezeichnung Goretex, Sympatex etc. für die Anwendung in Bekleidungsgegenständen bekannten Membrane. Die Membrane des Filters besteht aus einem feinen Geflecht oder Gewirk von Fasern. Eine sehr kleine Porengröße verhindert ein Eindringen der Schmutzpartikel und somit ein zum Teil irreversibles Zusetzen der Membrane. Gleichwohl können sich an der Oberfläche der Membrane Schmutzpartikel zu einem sogenannten Filterkuchen ablagern. In gleicher Weise können Flüssigkeiten bis zu einem speziellen Druck pro Flächeneinheit die Membrane nicht passieren.

Als Material wird für die Membran beispielsweise PTFE, auch unter dem Namen Teflon bekannt, verwendet. Die Membran wird in der Regel auf einem grob gewebten Trägermaterial wie beispielsweise Polyamid aufgetragen, um eine hohe Stabilität und Resistenz des Membranfilters MB zu erreichen.

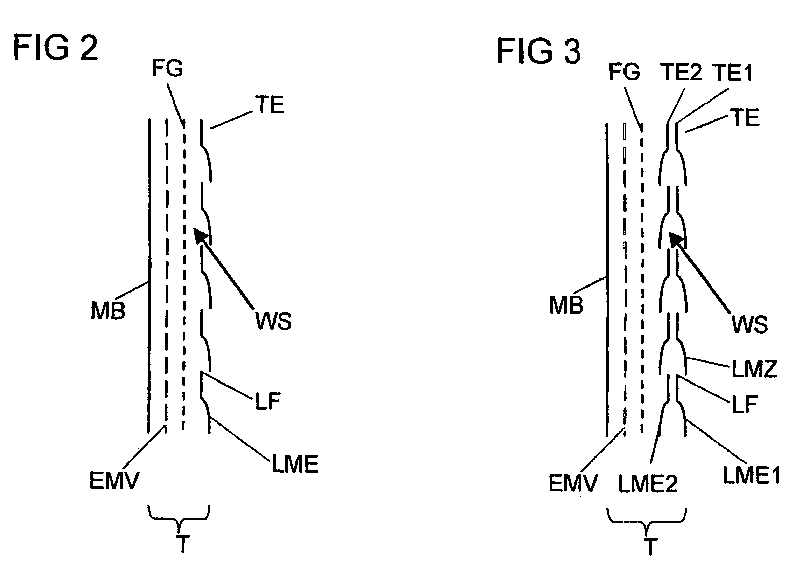

Fig. 2 zeigt im Querschnitt eine bekannte Wand bzw. Tür T, die ein Wand- oder Türelement TE aufweist. Dieses Wand- oder Türelement TE ist vorzugsweise aus Metall hergestellt. Entsprechende Kunststoffe können ebenfalls verwendet werden. Das Wand- bzw. Türelement TE weist an geeigneter Stelle Lüftungsöffnungen LF in Form horizontal verlaufender einseitiger Lamellen LME auf. Die einseitigen Lamellen LME überlappen sich dachziegelartig nach unten. Auf diese Weise kann ein horizontal verlaufender Wasserstrahl nicht durch die Lamellen LME durchdringen, allerdings dringt ein schräg nach oben gerichteter Wasserstrahl WS, der durch einen Pfeil symbolisiert ist, durch das Wand- bzw. Türelement TE durch. Auf der Rückseite des Wand- bzw. Türelements TE ist ein Fliegengitter FG ein EMV-Gitter EMV sowie das Membranfilter MB angeordnet. Dieses Membranfilter MB würde durch den Wasserstrahl WS ab einem gewissen Wasserdruck in Mitleidenschaft gezogen bzw. zerstört.

Fig. 3 zeigt eine Wand bzw. Tür T gemäß der Erfindung im Querschnitt, die ein Wand- bzw. Türelement TE aufweist. Das Wand- bzw. Türelement TE wird durch zwei Hälften T1 und T2 gebildet, die flächig miteinander verbunden werden, beispielsweise durch Schweißen oder Kleben. Jede Hälfte T1 und T2 des Wand- bzw. Türelements TE weist nach außen zeiaende sog. einseitige Lamellen LME1 und LME2 auf. Die Hälften T1 und T2 werden so zu einem Wand- bzw. Türelement TE zusammengefügt, daß die einfachen Lamellen LME1 und LME2 gegenüber angeordnet sind. Dadurch bilden sich übereinander greifende Lamellen LMZ, die im Querschnitt U- oder V-förmig sind und als zweiseitige Lamellen LMZ hier bezeichnet werden. Ein ungehinderter, geradlinig verlaufender Weg durch die zweiseitigen Lamellen LMZ ist daher nicht mehr möglich so daß das Wand- bzw. Türelement TE für einen direkten Wasserstrahl WS undurchlässig ist. Die sonstigen Elemente der Wand bzw. Tür in Fig. 3 entsprechen denjenigen der Fig. 2.

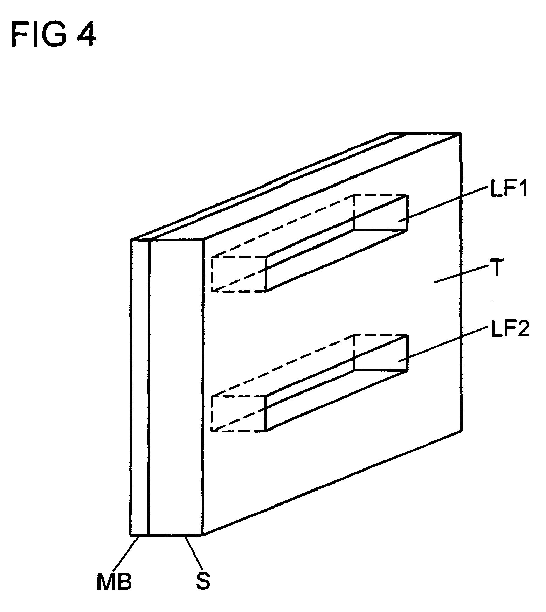

Fig. 4 zeigt einen Ausschnitt eines Wand- bzw. Türelements TE mit hinterspritzter Membrane in perspektivischer Darstellung. Dargestellt ist eine Membrane oder Membranfilter MB, vor bzw. hinter dem einerseits zur Stabilisierung der Membrane bzw. des Membranfilters MB und andererseits zur Bildung der Tür oder Wand T eine Schale S aus einem Kunststoff oder dergleichen, beispielsweise durch ein Spritzgußverfahren, angeordnet ist. Mit anderen Worten, die Membrane bzw. das Membranfilter MB ist einseitig beschichtet, wobei die Membranseite der Wand- bzw. Tür T als Innenseite bei einer entsprechenden Kühlanordnung verwendet wird. Durch das Spritzgußverfahren ist die Membrane MB mit der Schale S fest verbunden. Eine entsprechende Gestaltung der Spritzgußform realisiert Lufteinlässe LE1 und LE2 in der Wand- bzw. Tür T. Die Membran MB kann auch beidseitig mit einer Kunststoffschale S beschichtet sein (nicht dargestellt), wobei entsprechend der Anforderung unterschiedliche Kunststoffe verwendet werden können. Die Lufteinlässe L1, L2 können auch in der Form der oben geschilderten zweiseitigen Lamellen ausgeführt werden, oder derart gestaltet werden, daß eine Faltung des Membranfilters MB im Bereich der Lufteinlässe L1, L2 verwirklicht werden kann.

## Patentansprüche

1. Anordnung zum Kühlen von elektrischen Baugruppen (BG) unter Verwendung einer den elektrischen Baugruppen vorgelagerten Wand (T), bestehend aus einem mit Lüftungslöchern (LF, LF1, LF2) versehenen Wandelement (TE) und einem an der Innenseite des Wandelements (TE) angeordneten Membranfilter (MB), so dass die durch die Lüftungslöcher (LF, LF1, LF2) eintretende Luft durch das Membranfilter (MB) geführt wird,
**dadurch gekennzeichnet,**
**dass** das Membranfilter (MB) eine Faltung mit im wesentlichen senkrecht verlaufenden Längsfalten aufweist, die derart ausgestaltet ist, dass sich am Membranfilter bildende Feuchtigkeit nach unten abläuft.

2. Anordnung zum Kühlen von elektrischen Baugruppen (BG) unter Verwendung einer den elektrischen Baugruppen vorgelagerten Wand, bestehend aus einem mit Lüftungslöchern (LF, LF1, LF2) versehenen Wandelement (TE) und einem an der Innenseite des Wandelements (TE) angeordneten Membranfilter (MB), so daß die durch die Lüftungslöcher (LF, LF1, LF2) eintretende Luft durch das Membranfilter (MB) geführt wird, wobei das Membranfilter (MB) eine Faltung mit im wesentlichen horizontal verlaufenden Längsfalten aufweist
**dadurch gekennzeichnet,**
**dass** das Membranfilter (MB) eine Neigung gegenüber der Senkrechten aufweist, die derart ausgestaltet ist, dass sich an den Falten des Membranfilters (MB) bildende Feuchtigkeit nach unten abläuft.

3. Anordnung nach Anspruch 1, **dadurch gekennzeichnet, dass** das Membranfilter (MB) eine Neigung gegenüber der Senkrechten aufweist.

4. Anordnung nach einem der vorhergehenden Ansprüche, **dadurch gekennzeichnet,**
- **dass** das Membranfilter (MB) in einem Rahmen mit Rahmenfuß der Wand (T) angeordnet ist, und
- **dass** der Rahmenfuß eine Schräge aufweist, die so ausgebildet ist, dass vom Membranfilter (MB) ablaufende Feuchtigkeit von den elektrischen Baugruppen weg nach außen abgeleitet wird.

5. Anordnung nach Anspruch 4, **dadurch gekennzeichnet, dass** die Wand (T) in der Umgebung des Rahmenfußes Öffnungen zum Ablaufen des Wassers aufweist.

6. Anordnung nach einem der vorhergehenden Ansprüche, **dadurch gekennzeichnet, dass** das Membranfilter (MB) an seiner Außenseite eine entsprechend der gewünschten Wandform hinterspritzte Wandschale (S) aufweist, wobei an den Stellen des Lufteinlasses (LF1, LF2) kein Material angeordnet ist.

7. Anordnung nach einem der vorhergehenden Ansprüche, **dadurch gekennzeichnet, dass** das Wandelement (TE) auf zwei Seiten Lamellen (LMZ) aufweist, die ineinander versetzt derart angeordnet sind, dass jeder durch die Lamellenanordnung führende Weg eine Krümmung aufweist und ein geradliniger Durchtritt durch die Lamellenanordnung verhindert wird.

8. Anordnung nach Anspruch 7, **dadurch gekennzeichnet, dass** das Wandelement (TE) zwei Wandelementhälften (TE1, TE2) aufweist, wobei jede Wandelementhälfte (TE1, TE2) mit einseitigen Lamellen (LME1, LME2) versehen ist, so dass nach dem Zusammenfügen der beiden Wandelementhälften (TE1, TE2) ein Wandelement (TE) mit zweiseitigen Lamellen (LMZ) entsteht, die geradlinigen Durchtritt verhindert.

9. Anordnung nach Anspruch 8, **dadurch gekennzeichnet, dass** die einseitigen Lamellen (LME1, LME2) einer Wandelementhälfte (TE1, TE2) ausgestanzt werden.

10. Anordnung nach Anspruch 8 oder 9, **dadurch gekennzeichnet, dass** die Wandelementhälften (TE1, TE2) durch Fügetechniken wie Löten, Schweißen und/oder Kleben miteinander zu einem Wandelement (TE) flächig verbunden werden.

11. Anordnung nach einem der vorhergehenden Ansprüche, **dadurch gekennzeichnet, dass** die Wand (T) ein Fliegengitter (FG) aufweist, das vor der Membrane des Membranfilters (MB) an der Innenseite des Wandelements (TE) angeordnet ist.

12. Anordnung nach einem der vorhergehenden Ansprüche, **dadurch gekennzeichnet, dass** die Wand (T) eine EMV-Abschirmung (EMV) aufweist.

13. Anordnung nach einem der vorhergehenden Ansprüche, **dadurch gekennzeichnet, dass** die Wand (T) als eine Tür eines Gehäuses (G) ausgebildet ist.

14. Anordnung nach Anspruch 13, **dadurch gekennzeichnet, dass** das Gehäuse (G) mindestens eine Kühleinrichtung (VE) zum Aufbau einer Luftströmung aufweist.

15. Anordnung nach Anspruch 14 , **dadurch gekennzeichnet, dass** das Gehäuse (G) einen im Innern angeordneten Feuchtesensor und ein Heizelement, das vor dem Membranfilter (MB) angeordnet ist, aufweist, wobei das Heizelement einströmende Luft erwärmt, wenn der Feuchtigkeitsgehalt im Innern des Gehäuses einen vorbestimmten Wert übersteigt.

## Revendications

1. Dispositif pour refroidir des blocs électriques (BG) en utilisant une paroi (T) disposée devant les blocs électriques, composé d'un élément mural (TE) pourvu de trous d'aération (LF, LF1, LF2) et d'un filtre à membrane (MB) disposé à la face intérieure de l'élément de paroi (TE), si bien que l'air admis par les trous d'aération (LF, LF1, LF2) est conduit à travers le filtre à membrane (MB),
**caractérisé en ce que**
le filtre à membrane (MB) présente un pliage avec des plis longitudinaux au tracé sensiblement vertical, conçu de telle sorte que l'humidité se formant sur le filtre à membrane s'écoule vers le bas.

2. Dispositif pour refroidir des blocs électriques (BG) en utilisant une paroi disposée devant les blocs électriques, composé d'un élément mural (TE) pourvu de trous d'aération (LF, LF1, LF2) et d'un filtre à membrane (MB) disposés à la face intérieure de l'élément mural (TE), si bien que l'air admis par les trous d'aération (LF, LF1, LF2) est conduit à travers le filtre à membrane (MB), le filtre à membrane (MB) présentant un pliage aux plis longitudinaux au tracé sensiblement horizontal,
**caractérisé en ce que**
le filtre à membrane (MB) présente une inclinaison vis à vis de la verticale, conçue de telle sorte que l'humidité se formant aux plis du filtre à membrane (MB) s'écoule vers le bas.

3. Dispositif selon la revendication 1, **caractérisé en ce que** le filtre à membrane (MB) présente une inclinaison par rapport à la verticale.

4. Dispositif selon l'une des revendications précédentes, **caractérisé en ce que**
- le filtre à membrane (MB) est disposé dans un cadre avec un pied du cadre de la paroi (T) et
- le pied du cadre présente une inclinaison conçue de telle sorte que l'humidité s'écoulant du filtre à membrane (MB) est évacuée vers l'extérieur loin des blocs électriques.

5. Dispositif selon la revendication 4, **caractérisé en ce que** la paroi (T) présente à proximité du pied du cadre des orifices d'écoulement de l'eau.

6. Dispositif selon l'une des revendications précédentes, **caractérisé en ce que** le filtre à membrane (MB) présente à sa face extérieure une coquille de paroi (S) surmoulée conformément à la forme de paroi souhaitée, aucun matériau n'étant disposé aux points de la prise d'air (LF1, LF2).

7. Dispositif selon l'une des revendications précédentes, **caractérisé en ce que** l'élément de paroi (TE) présente des lamelles (LMZ) sur ses deux faces, disposées décalées les unes par rapport aux autres de telle sorte que tout passage menant à travers le dispositif à lamelles présente une courbure et empêche un passage rectiligne à travers ce même dispositif à lamelles.

8. Dispositif selon la revendication 7, **caractérisé en ce que** l'élément mural (TE) présente deux demi-éléments muraux (TE1, TE2), chaque demi-élément mural (TE1, TE2) étant pourvu de lamelles unilatérales (LME1, LME2), si bien qu'après l'assemblage des deux demi-éléments muraux (TE1, TE2), on obtient un élément mural (TE) à lamelles bilatérales (LMZ), qui empêche un passage rectiligne.

9. Dispositif selon la revendication 8, **caractérisé en ce que** les lamelles unilatérales (LME1, LME2) d'un demi-élément mural (TE1, TE2) sont poinçonnées.

10. Dispositif selon la revendication 8 ou 9, **caractérisé en ce que** les demi-éléments muraux (TE1, TE2) sont solidarisés sur un plan en un élément mural par des techniques d'assemblage comme le brasage, le soudage et/ou le collage.

11. Dispositif selon l'une des revendications précédentes, **caractérisé en ce que** la paroi (T) présente un grillage à mouches (FG), disposé en amont de la membrane du filtre à membrane (MB) à la face intérieure de l'élément mural (TE).

12. Dispositif selon l'une des revendications précédentes, **caractérisé en ce que** la paroi (T) présente un blindage à compatibilité électromagnétique (EMV).

13. Dispositif selon l'une des revendications précédentes, **caractérisé en ce que** la paroi (T) est conçue comme porte d'un boîtier (G).

14. Dispositif selon la revendication 13, **caractérisé en ce que** le boîtier (G) présente au moins un dispositif de refroidissement (VE) pour la formation d'un courant d'air.

15. Dispositif selon la revendication 14, **caractérisé en ce que** le boîtier (G) présente un détecteur d'humidité disposé à l'intérieur de celui-ci et un élément chauffant disposé en amont du filtre à membrane (MB), l'élément chauffant réchauffant l'air admis lorsque la teneur en humidité à l'intérieur du boîtier dépasse une valeur prédéterminée.

## Claims

1. Assembly for cooling electrical modules (BG) using a wall (T) which is mounted in front of the electrical modules, comprising a wall element (TE), which is provided with ventilation holes (LF, LF1, LF2), and a membrane filter (MB), which is arranged on the inner side of the wall element (TE), so that the air which enters through the ventilation holes (LF, LF1, LF2) is passed through the membrane filter (MB), **characterized in that** the membrane filter (MB) has a fold with substantially vertically running longitudinal folds, which is designed in such a manner that moisture which forms at the membrane filter drains away downward.

2. Assembly for cooling electrical modules (BG) using a wall which is mounted in front of the electrical modules, comprising a wall element (TE), which is provided with ventilation holes (LF, LF1, LF2), and a membrane filter (MB), which is arranged on the inner side of the wall element (TE), so that the air which enters through the ventilation holes (LF, LF1, LF2) is passed through the membrane filter (MB), the membrane filter (MB) having a fold with substantially horizontally running longitudinal folds, **characterized in that** the membrane filter (MB) has an inclination with respect to the vertical which is such that moisture which forms at the folds of the membrane filter (MB) drains away downward.

3. Assembly according to Claim 1, **characterized in that** the membrane filter (MB) is inclined with respect to the vertical.

4. Assembly according to one of the preceding claims, **characterized**
- **in that** the membrane filter (MB) is arranged in a frame with frame foot of the wall (T), and
- **in that** the frame foot has a slope which is such that moisture which drains out of the membrane filter (MB) is discharged outward away from the electrical modules.

5. Assembly according to Claim 4, **characterized in that** the wall (T) has openings for draining the water in the vicinity of the frame foot.

6. Assembly according to one of the preceding claims, **characterized in that** the membrane filter (MB) has, on its outer side, a wall shell (S) which is formed as a backing matching the desired wall shape by injection-moulding, without any material being arranged at the locations of the air inlet (LF1, LF2).

7. Assembly according to one of the preceding claims, **characterized in that** the wall element (TE) has, on two sides, lamellae (LMZ) which are set inside one another, so that each path leading through the arrangement of lamellae has a curvature and rectilinear passage through the arrangement of lamellae is prevented.

8. Arrangement according to Claim 7, **characterized in that** the wall element (TE) has two wall-element halves (TE1, TE2), each wall-element half (TE1, TE2) being provided with lamellae (LME1, LME2) on one side, so that after the two wall-element halves (TE1, TE2) have been joined a wall element (TE) with lamellae (LMZ) on two sides is formed, preventing rectilinear passage.

9. Assembly according to Claim 8, **characterized in that** the lamellae (LME1, LME2) on one side of a wall-element half (TE1, TE2) are stamped out.

10. Assembly according to Claim 8 or 9, **characterized in that** the wall-element halves (TE1, TE2) are surface-connected to one another to form a wall element (TE) by means of joining techniques, such as soldering, welding and/or adhesive bonding.

11. Assembly according to one of the preceding claims, **characterized in that** the wall (T) has a fly screen (FG) which is arranged in front of the membrane of the membrane filter (MB), on the inner side of the wall element (TE).

12. Assembly according to one of the preceding claims, **characterized in that** the wall (T) has an EMC shield (EMV).

13. Assembly according to one of the preceding claims, **characterized in that** the wall is designed as a door (T) of a housing (G).

14. Assembly according to Claim 13, **characterized in that** the housing (G) has at least one cooling device (VE) for building up an air flow.

15. Assembly according to Claim 14, **characterized in that** the housing (G) has a moisture sensor, which is arranged in the interior, and a heating element, which is arranged in front of the membrane filter (MB), the heating element heating air which flows in when the moisture content in the interior of the housing exceeds a predetermined level.
